(19) **Europäisches Patentamt**

**European Patent Office**

**Office européen des brevets**

(11) **EP 1 178 490 A1**

(12) **EUROPÄISCHE PATENTANMELDUNG**

(43) Veröffentlichungstag:
**06.02.2002 Patentblatt 2002/06**

(51) Int Cl.[7]: **G11C 11/16**, G11C 5/06, G11C 11/15

(21) Anmeldenummer: **01117216.0**

(22) Anmeldetag: **16.07.2001**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (72) Erfinder:<br>• **Gogl, Dietmar**<br>  **12524 Fishkill, NY (US)**<br>• **Kandolf, Helmut**<br>  **81669 Muenchen (DE)**<br>• **Lammers, Stefan**<br>  **South Burlington, VT 05403 (US)** |
| (30) Priorität: **03.08.2000 DE 10037976** | |
| (71) Anmelder: **Infineon Technologies AG**<br>**81669 München (DE)** | (74) Vertreter:<br>**Müller . Hoffmann & Partner Patentanwälte**<br>**Innere Wiener Strasse 17**<br>**81667 München (DE)** |

(54) **Anordnung zum verlustarmen Schreiben eines MRAMs**

(57) Die Erfindung betrifft eine Anordnung zum verlustarmen Schreiben eines MRAMs, bei der die an den Bitleitungen (BL0, ... BL4) bzw. Wortleitungen liegenden Spannungen derart eingestellt sind, daß die Zellspannung über den Speicherzellen (Z0, ..., Z4) zwischen einer selektierten Wortleitung (WL) bzw. Bitleitung und den einzelnen Bitleitungen (BL0, ..., BL4) bzw. Wortleitungen minimal ist.

**Fig. 1**

EP 1 178 490 A1

Printed by Jouve, 75001 PARIS (FR)

**Beschreibung**

Die vorliegende Erfindung betrifft eine Anordnung zum verlustarmen Schreiben eines MRAMs mit einer Vielzahl von Speicherzellen, die in einem Speicherzellenfeld jeweils zwischen Wortleitungen und Bitleitungen vorgesehen sind, wobei bei einem Schreibvorgang in eine bestimmte Speicherzelle auf der mit dieser Speicherzelle verbundenen selektierten Wort- bzw. Bitleitung ein Spannungsabfall auftritt.

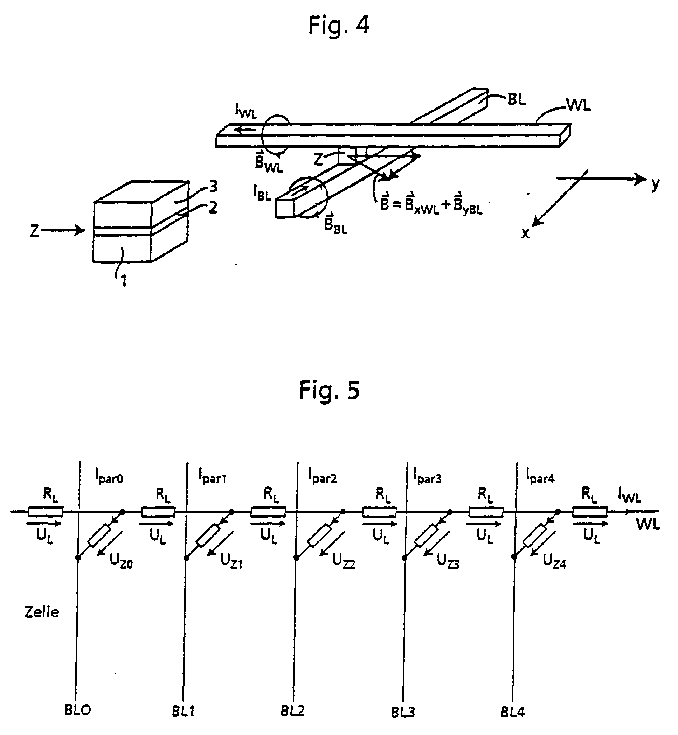

Fig. 4 zeigt schematisch eine MRAM-Zelle mit einer in y-Richtung verlaufenden Wortleitung WL und einer diese senkrecht im Abstand kreuzenden und in x-Richtung verlaufenden Bitleitung BL. Zwischen der Wortleitung WL und der Bitleitung BL liegt eine Speicherzelle Z, die in üblicher Weise aus einer hartmagnetischen Schicht 1, einer Tunnelbarrierenschicht 2 und einer weichmagnetischen Schicht 3 besteht, welche in einem Schichtstapel zwischen der Wortleitung WL und der Bitleitung BL angeordnet sind.

Um in eine solche MRAM-Zelle das gewünschte Datum abzuspeichern, werden auf der Wortleitung WL ein Strom $I_{WL}$ und auf der Bitleitung BL ein Strom $I_{BL}$ eingeprägt. Diese Ströme $I_{WL}$ und $I_{BL}$ erzeugen jeweils ein Magnetfeld $\bar{B}_{WL}$ bzw. $\bar{B}_{BL}$. An der Kreuzungsstelle der Wortleitung WL mit der Bitleitung BL, also im Bereich der Speicherzelle Z, liegen so aufgrund des durch die Wortleitung WL fließenden Stromes $I_{WL}$ ein in x-Richtung verlaufendes Magnetfeld $B_{xWL}$ und aufgrund des durch die Bitleitung BL fließenden Stromes $I_{BL}$ ein in y-Richtung verlaufendes Magnetfeld $B_{yBL}$ vor. Das aus der Summe der beiden Magnetfelder $B_{xWL}$ und $B_{yBL}$ gebildete Gesamtmagnetfeld B richtet die weichmagnetische Schicht 3 der Speicherzelle Z in eine bestimmte Richtung aus, die parallel oder antiparallel zu der Magnetisierung der hartmagnetischen Schicht 1 sein kann. Abhängig von der parallelen bzw. antiparallelen Magnetisierung der beiden Schichten 1 und 3, denen jeweils ein niedrigerer bzw. höherer Widerstandswert zugeordnet ist, speichert die Speicherzelle Z so eine logische "1" oder "0".

Bei einem Schreibvorgang fließt der Wortleitungsstrom $I_{WL}$ durch die Wortleitung WL. Da die Wortleitung WL aber bei jedem ihrer Teilstücke zwischen einzelnen Bitleitungen BL0, BL1, ... einen Widerstand $R_L$ hat, tritt infolge dieses Leitungswiderstandes längs der Wortleitung WL ein Spannungsabfall $U_L$ bei jedem Teilstück auf. Dieser Spannungsabfall $U_L$ ruft Spannungsdifferenzen $U_{Z0}$, $U_{Z1}$, $U_{Z2}$, ... über den einzelnen Speicherzellen Z hervor, welche parasitäre Ströme $I_{par0}$, $I_{par1}$, $I_{par2}$, ... durch die Speicherzellen Z fließen läßt, wie dies schematisch in Fig. 5 gezeigt ist.

Durch diese parasitären Ströme $I_{par0}$, $I_{par1}$, ... wird der in der Wortleitung WL fließende Strom $I_{WL}$ längs der Wortleitung WL geschwächt, so daß ein zuverlässiges Schreiben, das eine gewisse Stromstärke des Stromes $I_{WL}$ in der Wortleitung WL voraussetzt, nicht mehr gewährleistet werden kann. Mit anderen Worten, wegen der parasitären Ströme $I_{par0}$, $I_{par1}$, ... muß der in der Wortleitung WL fließende Strom $I_{WL}$ in seiner Stärke erhöht werden.

Eine solche Erhöhung des in der Wortleitung WL fließenden Stromes $I_{WL}$ ist aber eingeschränkt, da ein zu hoher Strom $I_{WL}$ in der Wortleitung WL dazu führen kann, daß alle Speicherzellen längs dieser Wortleitung WL ohne Mitwirkung einer jeweiligen Bitleitung BL0, BL1, ... beschrieben werden. Mit anderen Worten, bei einem zu hohen Strom in der Wortleitung WL ist eine Selektion der Speicherzellen nicht mehr möglich.

Um bei diesen Gegebenheiten die parasitären Ströme $I_{par0}$, $I_{par1}$, ... möglichst gering zu halten, könnte daran gedacht werden, entweder für einen möglichst hohen Widerstand der Speicherzellen zu sorgen oder aber die Länge der Wortleitungen WL zu verkürzen. Beide Maßnahmen sind aber mit nicht unerheblichen Nachteilen verbunden: hohe Widerstände der Speicherzellen verringern den Lesestrom durch diese und erschweren so ein zuverlässiges Auslesen. Kurze Wortleitungen verringern dagegen die Effizienz des MRAMs bzw. Speicherchips und verteuern so die Herstellungskosten. Entsprechende Überlegungen können auch für die Bitleitungen angestellt werden.

Es ist daher Aufgabe der vorliegenden Erfindung, eine Anordnung zum verlustarmen Schreiben eines MRAMs zu schaffen, welche weder hohe Widerstände der Speicherzellen noch kurze Wortleitungen und/oder Bitleitungen verwendet.

Zur Lösung dieser Aufgabe sieht die Erfindung eine Anordnung mit den Merkmalen des Patentanspruches 1 bzw. 6 vor. Vorteilhafte Weiterbildungen der Erfindung ergeben sich aus den Unteransprüchen.

Bei einer Anordnung der eingangs genannten Art sind also die an den Bitleitungen bzw. Wortleitungen liegenden Spannungen derart eingestellt, daß die Zellspannung über den Speicherzellen zwischen der selektierten Wortleitung bzw. selektierten Bitleitung und den einzelnen Bitleitungen bzw. Wortleitungen minimal ist.

Bei der erfindungsgemäßen Anordnung werden also die beim Schreiben entstehende Zellspannung und die durch die einzelnen Speicherzellen fließenden parasitären Ströme durch geeignete Einstellung bzw. Regelung der an den einzelnen Bitleitungen bzw. Wortleitungen liegenden Spannungen verkleinert bzw. sogar eliminiert.

Um dies zu erreichen, gibt es grundsätzlich zwei Varianten, wie dies im folgenden anhand einer selektierten Wortleitung erläutert werden soll. Die für diese selektierte Wortleitung beschriebenen Verhältnisse gelten sinngemäß auch für eine selektierte Bitleitung. Auch ist eine Kombination einer selektierten Wortleitung mit einer selektierten Bitleitung möglich: Während alle Bitleitungen auf eine Spannung der selektierten Wortleitung geregelt sind (vgl. Patentansprüche 2, 3 und 5) werden gleichzeitig alle Wortleitungen auf die Spannung der selektierten Bitleitung geregelt (vgl. Patentansprüche 7, 8 und 10).

(a) Wenn der Spannungsabfall längs einer Wortleitung die Größe V1 - V2 hat, wobei V1 die Spannung am einen Ende und V2 die Spannung am anderen Ende der Wortleitung bedeutet, dann werden alle Bitleitungen auf die Spannung (V1 + V2)/2 eingestellt. Es liegt dann eine maximale Zellspannung von ±(V1-V2)/2 vor. Das heißt, die parasitären Ströme, die in der einen Hälfte der Wortleitung über die Speicherzellen zufließen, fließen in der anderen Hälfte der Wortleitung wieder ab. Mit anderen Worten, bei dieser Variante werden die Bitleitungen alle auf ein geeignetes Äquipotential gelegt, das genau in der Mitte zwischen U1 und U2 liegt.

(b) Bei der zweiten Variante werden im Gegensatz zur Variante (a) die Spannungen der einzelnen Bitleitungen nicht auf ein Äquipotential eingestellt, sondern einzeln an den Spannungsabfall längs der Wortleitung angepaßt, so daß die Spannung über den einzelnen Speicherzellen annähernd Null ist und praktisch kein parasitärer Strom fließt. Da das Messen der Wortleitungsspannung an jeder einzelnen Speicherzelle längs der selektierten Wortleitung zur Gewinnung von Referenzspannungen viel Chipfläche erfordert, wird zweckmäßigerweise eine Referenzwortleitung eingeführt, die die selektierte Wortleitung nachbildet und von der die Referenzspannung abgenommen wird, welche mittels Spannungsfolger an die jeweilige Bitleitung angelegt wird. Zur weiteren Einsparung von Chipfläche können gegebenenfalls auch mehrere Bitleitungen zu einer Gruppe zusammengefaßt und auf ein Äquipotential gelegt werden, welches den Mittelwert der Spannung in jeweils dieser Gruppe von Bitleitungen zugeordneten Teil der Wortleitung entspricht.

Nachfolgend wird die Erfindung anhand der Zeichnungen näher erläutert. Es zeigen:

Fig. 1 ein schematisches Schaltbild zur Erläuterung eines ersten Ausführungsbeispiels der erfindungsgemäßen Anordnung,

Fig. 2 den Spannungsverlauf längs der Wortleitung bei dem Ausführungsbeispiel von Fig. 1,

Fig. 3 ein schematisches Schaltbild zur Erläuterung eines zweiten Ausführungsbeispiels der erfindungsgemäßen Anordnung,

Fig. 4 den Aufbau einer herkömmlichen Speicherzelle an der Kreuzungsstelle einer Wortleitung mit einer Bitleitung bei einem MRAM und

Fig. 5 ein schematisches Schaltbild zur Erläuterung der Entstehung von parasitären Strömen.

Die Fig. 4 und 5 sind bereits eingangs erläutert worden.

In den Figuren werden einander entsprechende Bauteile jeweils mit den gleichen Bezugszeichen versehen.

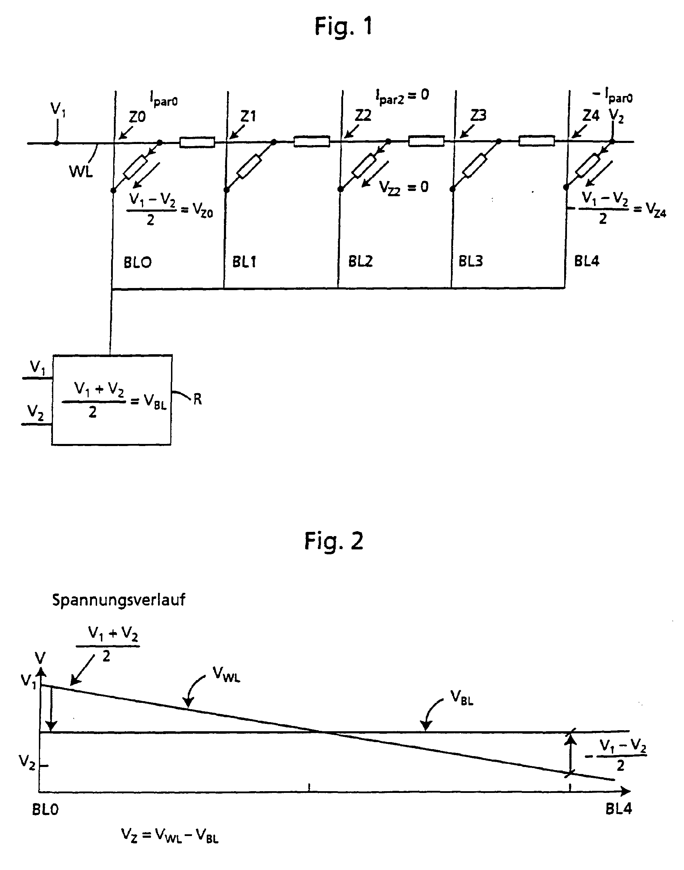

Fig. 1 zeigt ein erstes Ausführungsbeispiel der erfindungsgemäßen Anordnung. Bei diesem Ausführungsbeispiel wird angenommen, daß das eine Ende der Wortleitung WL auf einem Potential V1 liegt, während das andere Ende dieser Wortleitung WL mit dem Potential V2 beaufschlagt ist. Damit tritt an der Wortleitung WL ein Spannungsabfall V1 - V2 auf.

Mit Hilfe eines Reglers R, dem ebenfalls die Spannungen V1 und V2 zugeführt sind, wird eine Spannung $(V1 + V2)/2 = V_{BL}$ erzeugt, welche über einzelne, in Fig. 1 nicht gezeigte Schalter den Bitleitungen BL0, BL1, ... zugeführt werden kann.

Fig. 2 zeigt den Verlauf der Spannung $V_{WL}$ längs der Wortleitung WL sowie den Verlauf der Spannung $V_{BL}$ über den einzelnen Bitleitungen BL. Wie aus dieser Fig. 2 zu ersehen ist, treten bei dem Ausführungsbeispiel von Fig. 1 über der Speicherzelle an der Kreuzung der Wortleitung WL mit der Bitleitung BL0 ein Spannungsabfall $(V1 - V2)/2 = V_{Z0}$ und über der Speicherzelle an der Kreuzung der Wortleitung WL mit der Bitleitung BL4 ein Spannungsabfall $- (V1 - V2)/2 = V_{Z4}$ auf.

Bei der Speicherzelle an der Kreuzung der Bitleitung BL2 mit der Wortleitung WL, also an der Schnittstelle der Spannungskurve $V_{WL}$ mit der Spannungskurve $V_{BL}$, herrscht dagegen eine Zellspannung $V_{Z2} = 0$.

Bei diesem Ausführungsbeispiel der Fig. 1 und 2 fließt so der parasitäre Strom, der in der einen Hälfte der Wortleitung WL über die Zellen Z0 und Z1 abfließt, über die Zellen Z3 und Z4 wieder zu. Das heißt, der parasitäre Strom $I_{par0}$ durch die Zelle Z0 fließt als Strom $-I_{par0}$ über die Zelle Z4 wieder zu, wobei entsprechende Verhältnisse für die Zellen Z1 und Z3 vorliegen und der parasitäre Strom $I_{par2}$ durch die parasitäre Zelle Z2 den Wert 0 hat.

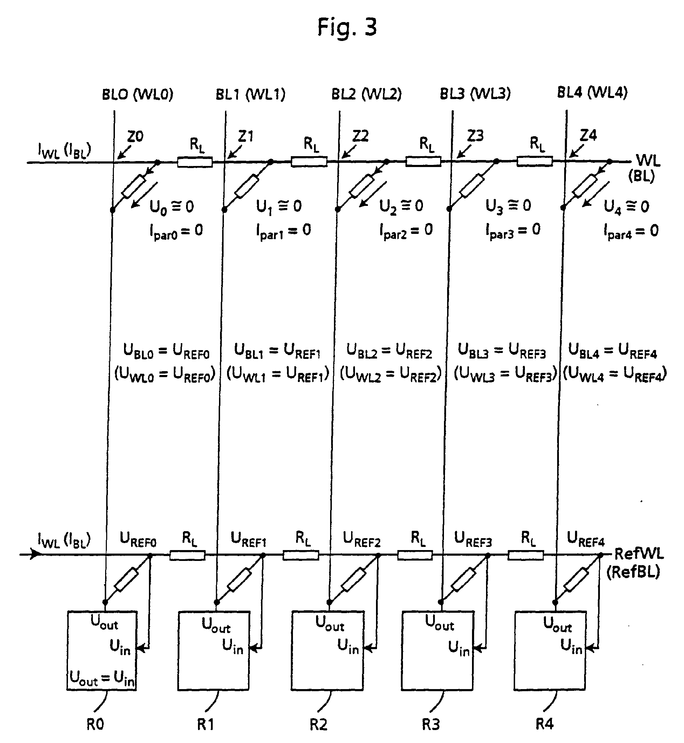

Fig. 3 zeigt ein zweites Ausführungsbeispiel der erfindungsgemäßen Anordnung. Bei diesem Ausführungsbeispiel werden die Bitleitungsspannungen $U_{BL0}$, $U_{BL1}$, ... im Gegensatz zum Ausführungsbeispiel der Fig. 1 und 2 nicht auf ein Äquipotential eingestellt, sondern einzeln an den Spannungsabfall in der Wortleitung WL, in der der Strom $I_{WL}$ fließt, angepaßt. Dadurch wird erreicht, daß die Spannungsabfälle $U_0$, $U_1$, ... über den einzelnen Speicherzellen Z0, Z1, ... und die parasitären Ströme $I_{par0}$, $I_{par1}$, ... jeweils annähernd Null sind.

Um dies zu erreichen, wird eine Referenzwortleitung RefWL eingeführt, die die selektierte Wortleitung WL nachbildet und an der die einzelnen Referenzspannungen $U_{REF0}$, $U_{REF1}$, ... bei den einzelnen Referenzzellen gemessen werden. diese Referenzspannungen $U_{REF0}$, $U_{REF1}$, ... werden in jeweilige Regler R1, R2, ... als Spannungen $U_{IN}$ eingegeben und als Ausgangsspannungen $U_{OUT}$ dieser Regler den Bitleitungen BL0, BL1, ... zugeführt, so daß allgemein gilt $U_{BL0} = U_{REF0}$, $U_{BL1} = U_{REF1}$, ... Damit werden parasitäre Ströme praktisch ausgeschlossen, so daß $I_{par0} = 0$, $I_{par1} = 0$ usw. vorliegt.

Gegebenenfalls ist es möglich, mehrere Bitleitungen, beispielsweise die Bitleitungen BL0 und BL1 zu einer Gruppe zusammenzufassen und auf ein Äquipotential zu legen, welches dem Mittelwert der Spannung im zugeordneten Teil der Wortleitung WL entspricht.

Wie bereits mehrfach erwähnt wurde, kann die Erfindung in gleicher Weise auch auf eine selektierte Bitleitung angewandt werden. Im Ausführungsbeispiel von Fig. 3 liegen dann, wie dies in Klammern angegeben ist, Wortleitungen WL0, WL1, ... WL4, einer Bitleitung BL und eine Referenzbitleitung RefBL vor. In der Bitleitung BL und der Referenzbitleitung RefBL fließt jeweils ein Strom $I_{BL}$, und für die Wortleitungsspannung gelten $U_{WL0} = U_{REF0}$, $U_{WL1} = U_{REF1}$, ... $U_{WL4} = U_{REF4}$.

**Patentansprüche**

1. Anordnung zum verlustarmen Schreiben eines MRAMs mit einer Vielzahl von Speicherzellen (Z0, Z1, ...), die in einem Speicherzellenfeld jeweils zwischen Wortleitungen (WL) und Bitleitungen (BL; BL0, BL1, ...) vorgesehen sind, wobei bei einem Schreibvorgang in eine bestimmte Speicherzelle auf der mit dieser Speicherzelle verbundenen selektierten Wortleitung (WL) ein Spannungsabfall (V1 - V2) auftritt,
**dadurch gekennzeichnet, daß**
die an den Bitleitungen (BL; BL0, BL1, ...) liegenden Spannungen derart eingestellt sind, daß die Zellspannung über den Speicherzellen (Z0, Z1, ...) zwischen der selektierten Wortleitung (WL) und den einzelnen Bitleitungen (BL; BL0, BL1, ...) minimal ist.

2. Anordnung zum verlustarmen Schreiben eines MRAMs mit einer Vielzahl von Speicherzellen (Z0, Z1, ...), die in einem Speicherzellenfeld jeweils zwischen Wortleitungen (WL) und Bitleitungen (BL; BL0, BL1, ...) vorgesehen sind, wobei bei einem Schreibvorgang in eine bestimmte Speicherzelle auf der mit dieser Speicherzelle verbundenen selektierten Wortleitung (WL) ein Spannungsabfall (V1 - V2) auftritt,
**dadurch gekennzeichnet, daß**
dann, wenn an den beiden Enden der selektierten Wortleitung (WL) eine Spannung V1 bzw. eine Spannung V2 < V1 anliegt, alle Bitleitungen (BL; BL0, BL1 ...) auf Spannungen (V1 + V2)/2 eingestellt sind, so daß die Zellspannung maximal ±V1-V2)/2 beträgt.

3. Anordnung nach Anspruch 1,
**dadurch gekennzeichnet, daß**
die Bitleitungen (BL; BL0, BL1, ...) auf das gleiche Potential wie die Wortleitung (WL) bei deren jeweiligen, den einzelnen Bitleitungen (BL; BL0, BL1, ...) zugeordneten Teilen gelegt sind.

4. Anordnung nach Anspruch 3,
**gekennzeichnet durch**
eine Referenzwortleitung (RefWL), die die selektierte Wortleitung (WL) nachbildet.

5. Anordnung nach Anspruch 3 oder 4,
**dadurch gekennzeichnet, daß**
mehrere Bitleitungen (BL; BL0, BL1, ...) zu einer Gruppe zusammengefaßt und auf ein Äquipotential gelegt sind, das den Mittelwert der Spannung in dem dieser Gruppe zugeordneten Teil der Wortleitung (WL) entspricht.

6. Anordnung zum verlustarmen Schreiben eines MRAMs mit einer Vielzahl von Speicherzellen (Z0, Z1, ...), die in einem Speicherzellenfeld jeweils zwischen Wortleitungen (WL) und Bitleitungen (BL; BL0, BL1, ...) vorgesehen sind, wobei bei einem Schreibvorgang in eine bestimmte Speicherzelle auf der mit dieser Speicherzelle verbundenen selektierten Bitleitungen (BL) ein Spannungsabfall (V1 - V2) auftritt,
**dadurch gekennzeichnet, daß**
die an den Wortleitungen (WL) liegenden Spannungen derart eingestellt sind, daß die Zellspannung über den Speicherzellen (Z0, Z1, ...) zwischen der selektierten Bitleitung (BL) und den einzelnen Wortleitungen (WL) minimal ist.

7. Anordnung zum verlustarmen Schreiben eines MRAMs mit einer Vielzahl von Speicherzellen (Z0, Z1, ...), die in einem Speicherzellenfeld jeweils zwischen Wortleitungen (WL) und Bitleitungen (BL; BL0, BL1, ...) vorgesehen sind, wobei bei einem Schreibvorgang in eine bestimmte Speicherzelle auf der mit dieser Speicherzelle verbundenen selektierten Bitleitungen (BL) ein Spannungsabfall (V1 - V2) auftritt,
**dadurch gekennzeichnet, daß**
dann, wenn an den beiden Enden der selektierten Bitleitung (BL) eine Spannung V1 bzw. eine Spannung V2 < V1 anliegt, alle Wortleitungen (WL) auf Spannungen (V1 + V2)/2 eingestellt sind, so daß die Zellspannung maximal ±V1 - V2)/2 beträgt.

8. Anordnung nach Anspruch 6,
**dadurch gekennzeichnet, daß**
die Wortleitungen (WL) auf das gleiche Potential wie die Bitleitung (BL) bei deren jeweiligen, den einzelnen Wortleitungen (WL) zugeordneten Teilen gelegt sind.

**9.** Anordnung nach Anspruch 8,
**gekennzeichnet durch**
eine Referenzbitleitung (RefBL), die die selektierte Bitleitung (BL) nachbildet.

**10.** Anordnung nach Anspruch 8 oder 9,
**dadurch gekennzeichnet, daß**
mehrere Wortleitungen (WL) zu einer Gruppe zusammengefaßt und auf ein Äquipotential gelegt sind, das den Mittelwert der Spannung in dem dieser Gruppe zugeordneten Teil der Wortleitung (BL) entspricht.

# Fig. 1

# Fig. 2

Spannungsverlauf

$$V_Z = V_{WL} - V_{BL}$$

## Fig. 3

# Fig. 4

# Fig. 5

**Europäisches Patentamt**

## EUROPÄISCHER RECHERCHENBERICHT

Nummer der Anmeldung

EP 01 11 7216

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 4 338 678 A (AKATSUKA YASUO) 6. Juli 1982 (1982-07-06) * Ansprüche 1,2 * ----- | 1 | G11C11/16 G11C5/06 G11C11/15 |

RECHERCHIERTE SACHGEBIETE (Int.Cl.7)

G11C

Der vorliegende Recherchenbericht wurde für alle Patentansprüche erstellt

| Recherchenort | Abschlußdatum der Recherche | Prüfer |
|---|---|---|
| DEN HAAG | 30. Oktober 2001 | Degraeve, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

ANHANG ZUM EUROPÄISCHEN RECHERCHENBERICHT
ÜBER DIE EUROPÄISCHE PATENTANMELDUNG NR.

EP 01 11 7216

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-10-2001

| Im Recherchenbericht angeführtes Patentdokument | Datum der Veröffentlichung | Mitglied(er) der Patentfamilie | Datum der Veröffentlichung |
|---|---|---|---|
| US 4338678 A | 06-07-1982 | JP 1496408 C | 16-05-1989 |
| | | JP 55150189 A | 21-11-1980 |
| | | JP 63001678 B | 13-01-1988 |
| | | DE 3065755 D1 | 05-01-1984 |
| | | EP 0019241 A1 | 26-11-1980 |

Für nähere Einzelheiten zu diesem Anhang : siehe Amtsblatt des Europäischen Patentamts, Nr.12/82

EPO FORM P0461